# EUROPÄISCHE PATENTSCHRIFT

(11) **EP 1 068 657 B1**
(45) Veröffentlichungstag und Bekanntmachung des Hinweises auf die Patenterteilung: **13.02.2002**
(21) Anmeldenummer: 99915623.5
(22) Anmeldetag: 16.03.1999
(51) Int. Cl.: H02B 1/20, H05K 7/14

(54) **VERNETZUNGSBAUSTEIN**
INTERCONNECTING MODULE
MODULE D'INTERCONNEXION

(30) Priorität: 02.04.1998 DE 19814810
(43) Veröffentlichungstag der Anmeldung: 17.01.2001
(73) Patentinhaber: Moeller GmbH, 53115 Bonn (DE)
(72) Erfinder: BENDER, Martin-Georg, D-65385 Rüdesheim am Rhein (DE); MÜSSELER, Willi, D-53347 Alfter (DE)
(86) Internationale Anmeldenummer: EP9901714
(87) Internationale Veröffentlichungsnummer: WO9952185

(56) Entgegenhaltungen:
- EP-A- 0 788 205
- DE-A- 4 440 602

## Beschreibung

### Technisches Gebiet

Die Erfindung betrifft ein Vemetzungsbaustein nach dem Oberbegriff des Anspruches 1.

### Stand der Technik

Aus der Druckschrift DE 93 05 529 U1 ist ein Vernetzungsbaustein für mehrere anzusteuernde und/oder ansteuernde elektrische Einrichtungen, mit einem aus einem Oberteil und einem Unterteil bestehenden Formgehäuse sowie mit Anschlußmitteln und Ausnehmungen für zwei zwischen Oberteil und Unterteil einzulegenden Busleitungen bekannt. Im allgemeinen dient eine der Busleitungen als Logikbus und die andere Busleitung zur Übertragung der Hilfsenergie für die elektrischen Einrichtungen. Von Nachteil ist, daß für mehrere busseitig gekoppelte Vernetzungsbausteine bzw. den damit verbundenen elektrischen Einrichtungen keine Auswahlmöglichkeiten bezüglich ihrer Hilfsenergie bestehen. So wird z.B. in der Firmenschrift der Klöckner-Moeller GmbH "Interfaceschütze DIL - kraftvolle Kontakte zwischen SPS und Verbraucher -" (10/91 VER 21-773 FLS/Wi) Seite 7, eine Schaltungsanordnung für die Steuerung von elektrischen Einrichtungen über eine speicherprogrammierbare Steuerung angegeben, bei der die Hilfsenergie für sicherheitsrelevante elektrische Einrichtungen in einer Notaus-Situation über einen Notaus-Befehlsgerät abgeschaltet wird, während die Hilfsenergie für die restlichen, unkritischen elektrischen Einrichtungen nicht unterbrochen wird.

Die Druckschrift DE 44 40 602 A1 offenbart eine Einrichtung zum Sichern von elektrischen Leitungen für mindestens eine elektrische Einrichtung in Form eines Schutzschalters mit einem Formgehäuse sowie mit Anschlußmitteln für zwei Busleitungen. Diese Druckschrift offenbart weiterhin Anschlußmittel in Form von äußeren, großen Buchsenkontakten für ein zusammengehöriges Paar massiver Sammelschienen zur Versorgung von Verbrauchern mit Hauptenergie sowie Anschlußmittel in Form von inneren, kleinen Buchsenkontakten für eine Signalisierungsleitung zur Aktivierung eines Anzeigeelementes. Die Druckschrift EP 0 788 205 A2 offenbart eine Anordnung zur Verteilung elektrischer Energie mit einem zusammengehörigen Quadrupel von Stromschienen zur Weiterleitung der Hauptenergie an mit der Anordnung verbundene Leistungsschalter. Die beiden vorbezeichneten Druckschriften stehen weder im Zusammenhang mit einem Logikbus noch mit Energiebussen für Hilfsenergien.

### Darstellung der Erfindung

Der Erfindung liegt daher die Aufgabe zugrunde, eine einfache und unaufwendige Auswahlmöglichkeit hinsichtlich der Hilfsenergie für über Vernetzungsbausteine anzusteuernde bzw. ansteuernde elektrische Einrichtungen anzugeben.

Ausgehend von einem Vernetzungsbaustein der eingangs genannten Art wird die Aufgabe erfindungsgemäß durch die kennzeichnenden Merkmale des unabhängigen Anspruches gelöst, während den abhängigen Ansprüchen vorteilhafte Weiterbildungen der Erfindung zu entnehmen sind.

Durch die Schaffung weiterer Anschlußmittel für eine dritte, eine weitere Hilfsenergie führende Busleitung können über den jeweiligen Vernetzungsbaustein die anzusteuernden und/oder ansteuernden elektrischen Einrichtungen mit zwei verschiedenen Hilfsenergien versorgt werden, wodurch sich zusätzliche Anwendungsmöglichkeiten für busvernetzte elektrische Einrichtungen ergeben.

Eine besonders vorteilhafte Weiterbildung der Erfindung besteht darin, daß über die Anschfußmittel eine über Notaus abschaltbare oder eine bei Notaus nicht abschaltbare Hilfsenergie den mit dem Vernetzungsbaustein verbundenen Einrichtungen zugeführt werden kann, so daß je nach Erfordernis sicherheitsrelevante Einrichtungen infolge Abschaltung ihrer Hilfsenergie sofort und unabhängig von dem über den Logikbus gerade stattfindenden Steuerregime auf eine Notaus-Abschaltung reagieren, während unkritische Einrichtungen bei bestehender Hilfsenergie später abgeschaltet werden können.

Über die Anschlußmittel können mit Vorteil auch Energiebusse abgegriffen werden, die sich hinsichtlich ihrer Spannungshöhe, beispielsweise 24 Volt oder 230 Volt, oder/und Gleich- oder Wechselspannung unterscheiden. So werden dem Anwender vielfältige Möglichkeiten für eine zweckmäßige Auswahl der zu verwendenden elektrischen Einrichtungen hinsichtlich der von diesen benötigten Hilfsenergie in die Hand zu geben.

Eine weitere vorteilhafte Weiterbildung besteht darin, daß mit Hilfe von besonderen elektrischen Verbindungsmitteln jeweils nur eine der beiden Hilfsenergien zu den angeschlossenen Einrichtungen geführt wird, wobei alle drei Busleitungen mit dem Vemetzungsbaustein verbunden sein können. Damit können bei mehreren vernetzten Vemetzungsbausteinen alle drei Busleitungen hindurchgeschleift werden, jedoch wird den an einigen der Vernetzungsbausteine angeschlossenen elektrischen Einrichtungen die erste Hilfsenergie, dagegen den an den übrigen Vemetzungsbausteinen angeschlossenen Einrichtungen die zweite Hilfsenergie zugeführt, während die an alle Vernetzungsbausteine angeschlossenen Einrichtungen über den Logikbus angesteuert werden bzw. ansteuem.

Vorteilhaft sind die elektrischen Verbindungsmittel als von den Anschlußmitteln räumlich getrennte Kontaktmittel ausgeführt, zweckmäßigerweise als trennbare Kontaktpaare. Durch Versetzung der zugehörigen stiftförmigen Kontakte kann eine Auswahl zwischen den beiden Hilfsenergien getroffen werden. Die stiftförmigen und die aufnehmenden Kontakte können auch in einem Kontaktmodul zur Weiterleitung der Logiksignale und nur einer der beiden Hilfsenergien angeordnet werden, das zur Auswahl der betreffenden Hilfsenergie entweder in zwei zueinander versetzten Positionen im Vernetzungsbaustein eingesetzt werden kann oder in zwei unterschiedlichen Ausführungsformen vorgesehen ist, so daß neben den Logiksignalen entweder nur die eine oder nur die andere Hilfsenergie weitergeleitet wird. Wenn das Formgehäuse des Vemetzungsbausteins aus einem Oberteil und einem Unterteil besteht, dann lassen sich die Kontaktmittel mit Vorteil im Unterteil bzw. Oberteil so anordnen, daß beim Zusammenfügen bzw. Auseinanderführen von Oberteil und Unterteil die Kontaktmittel kontaktieren bzw. öffnen, wobei im geöffneten Zustand bequem die vorbeschriebenen Veränderungen zur Auswahl der gewünschten Hilfsenergie vorgenommen werden können.

Die elektrischen Verbindungsmittel lassen sich auch vorteilhaft durch ein Anschlußmodul realisieren, das die Anschlußmittel für den Logikbus und nur eine der beiden Energiebusleitungen enthält und das zur Auswahl der betreffenden Hilfsenergie entweder in zwei zueinander versetzten Positionen im Vernetzungsbaustein eingesetzt werden kann oder in zwei unterschiedlichen Ausführungsformen vorgesehen ist, so daß neben den Logiksignalen entweder nur die eine oder nur die andere Hilfsenergie weitergeleitet wird. Das Anschlußmodul läßt sich ebenfalls mit Vorteil bei einem in ein Oberteil und ein Unterteil aufgeteiltes Formgehäuse einsetzen, versetzen bzw. austauschen, wobei das Anschlußmodul im Bereich der Ausnehmungen, die für die zwischen Oberteil und Unterteil einzulegenden Busleitungen vorgesehen sind, anzuordnen ist.

Wenn die von den beiden Busleitungen abgegriffenen Hilfsenergien zu jeweiligen Anschlußklemmen am Formgehäuse geführt werden, kann anwenderseitig durch Anschließen der Einrichtungen an die entsprechenden Anschlußklemmen eine der beiden Hilfsenergien ausgewählt werden.

Die vorbeschriebene Lösung und Weiterbildungen lassen sich auch auf den denkbaren Fall der Verwendung von mehr als drei Busleitungen übertragen, wenn dementsprechend mehr Anschlußmittel vorgesehen sind.

### Kurze Beschreibung der Zeichnungen

Weitere Einzelheiten und Vorteile der Erfindung ergeben sich aus dem folgenden, anhand von Figuren erläuterten Ausführungsbeispiel. Es zeigen
- Figur 1:: einen erfindungsgemäßen Vernetzungsbaustein in geöffnetem Zustand in perspektivischer Darstellung;
- Figur 2:: eine Einzelheit aus Fig. 1 in perspektivischer Explosivdarstellung in gegenüber Fig. 1 verlagerter Blickrichtung.

### Bester Weg zur Ausführung der Erfindung

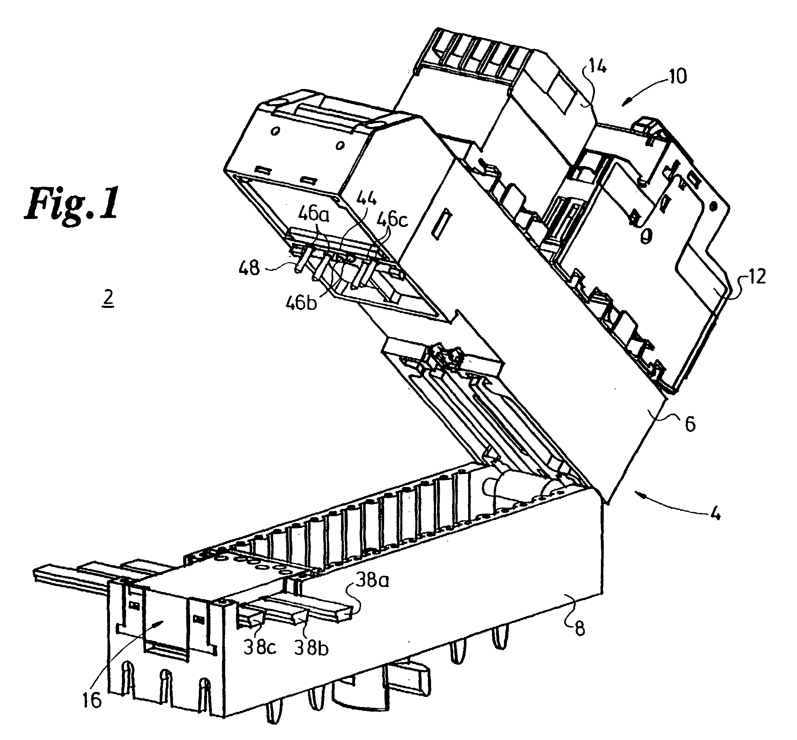

Nach Fig. 1 ist der Vernetzungsbaustein 2 von einem Formgehäuse 4 umschlossen, das aus einem Oberteil 6 und einem Unterteil 8 besteht, wobei zum Öffnen des Formgehäuses 4 das Oberteil 6 von dem Unterteil 8 abgeschwenkt werden kann. Auf dem Oberteil 6 sind elektrische Einrichtungen 10, in diesem Falle eine aus einem Motorschutzschalter 12 und einem Schütz 14 bestehende Motor-Starterkombination, montiert, wobei die elektrischen Verbindungen aus Gründen der Vereinfachung nicht dargestellt sind. Im Unterteil 8 ist eine Anschlußmodul 16 eingesetzt.

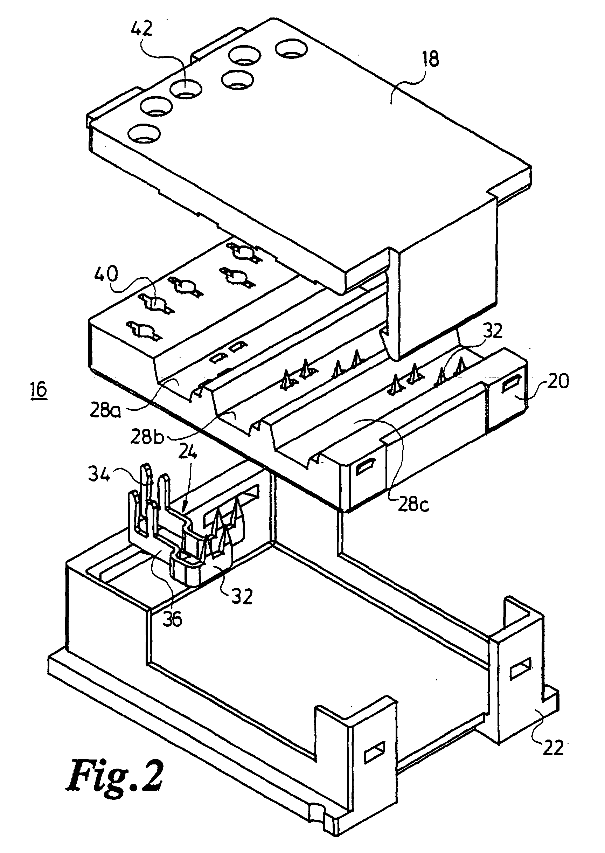

Das Anschlußmodul 16 besteht nach Fig. 2 aus einem Deckelteil 18, einem Zwischenteil 20 und aus einem Aufnahmeteil 22. In dem Zwischenteil 22 sind drei Paare von jeweils zwei elektrisch leitenden Teilen 24 eingesetzt. Das Zwischenteil 20 wird mit den leitenden Teilen 24 in das Aufnahmeteil 22 eingesetzt. Im Zwischenteil 20 sind drei durchgehende Ausnehmungen 28a, 28b, 28c ausgebildet. Die leitenden Teile 24 bestehen jeweils an einem Ende aus spitz auslaufenden und aus den Ausnehmungen 28a, 28b, 28c ragenden Anschlußmitteln 32, am anderen Ende aus einem aufnehmenden Kontakt 34 und einem beide Enden verbindenden Zwischenstück 36. In die Ausnehmungen 28a, 28b, 28c werden drei Busleitungen 38a, 38b, 38c eingelegt, deren Isolation von den Anschlußmitteln 32 kontaktierend durchdrungen werden, und beim verrastenden Aufsetzen des Deckelteils 18 festgelegt. Die aufnehmenden Kontakte 34 laufen in buchsenartigen Öffnungen 40 des Zwischenteils 20 aus, die ihrerseits bei aufgesetztem Deckelteil 18 mit Durchbrüchen 42 des Deckelteils 18 fluchten.

Gemäß Fig. 1 ist im Oberteil 6 ein Kontaktmodul 44 eingesetzt, das drei Paare von ersten bis dritten Steckplätzen 46a, 46b und 46c aufweist, die mit zwei Paaren von stiftförmigen Kontakten 48 besetzt sind. Beim Schließen des Formgehäuses 4 durch Zusammenschwenken von Oberteil 6 mit Unterteil 8 gelangen die Kontaktmittel, bestehend aus den stiftförmigen and den aufnehmenden Kontakten 48 und 34 in Verbindung, so daß über diese elektrischen Verbindungsmittel eine Verbindung zwischen zwei der Busleitungen 38a, 38b, 38c und dem Oberteil 6 zur Weiterleitung bzw. Verarbeitung hergestellt ist.

In dem dargestellten Beispiel dient die erste Busleitung 38a als Logikbus zur Übertragung der zwischen dem Bussystem und den Einrichtungen 10 auszutauschenden Informationen. Die zweite Busleitung 38b dient als Energiebus, der ständig eine Hilfsenergie für gewisse Steuerorgane der elektrischen Einrichtungen 10 führt. Die dritte Busleitung 38c dient als ein weiterer Energiebus, der eine weitere Hilfsenergie führt, die nur solange zur Verfügung steht, bis infolge einer sicherheitsrelevanten kritischen Situation eine Notaus-Abschaltung, beispielsweise mittels eines Notaus-Befehlsgerätes erfolgt. Durch Abschaltung dieser weiteren Hilfsenergie werden über die genannten Steuerorgane der Einrichtungen 10 die von den Einrichtungen 10 anzusteuernden Betriebsmittel, beispielsweise ein Motorantrieb, unmittelbar in einen Sicherheitszustand überführt.

Wenn eine Vielzahl elektrischer Einrichtungen 10 über mehrere Vernetzungsbausteine 2 über das Bussystem vemetzt ist, dann werden alle drei Busleitungen 38a, 38b 38c durch die Vernetzungsbausteine 2 geschleift. Im allgemeinen sind alle Einrichtungen 10 über ihren jeweiligen Vernetzungsbaustein 2 mit der ersten Busleitung 38a gekoppelt, wobei jedoch eine erste Gruppe der Vernetzungsbausteine 10 nur die Hilfsenergie der zweiten Busleitung 38b und die verbleibende zweite Gruppe der Vernetzungsbausteine 2 nur die Hilfsenergie der dritten Busleitung 38c an ihre jeweiligen Einrichtungen 10 weiterführt. Bei einer Notaus-Abschaltung werden demnach die zur zweiten Gruppe gehörenden Einrichtungen 10 unmittelbar und unabhängig vom jeweils aktuellen logischen Zustand des Bussystems in einen sicheren Zustand überführt, während die Zustandsänderung der zur ersten Gruppe gehörenden Einrichtungen allein über den Logikbus erfolgt.

Der Vernetzungsbaustein 2 wird für den einen oder den anderen Fall in der Weise zugerüstet, indem entweder die zweiten Steckplätze 46b (für die Verbindungherstellung zur zweiten Busleitung 38b) oder die dritten Steckplätze 46c (für die Verbindungsherstellung zur dritten Busleitung 38c) mit stiftförmigen Kontakten 48 besetzt werden, während die jeweils anderen Steckplätze 46c bzw. 46b frei bleiben. Im allgemeinen sind zur Kopplung mit der ersten Busleitung 38a die ersten Steckplätze 46a immer mit stiftförmigen Kontakten 48 besetzt. Die Umrüstung des Vernetzungsbausteins 2 kann in einer ersten Weise dadurch erfolgen, daß die stiftförmigen Kontakte 48 zwischen den zweiten und den dritten Steckplätzen 46b bzw. 46c umzustecken sind. Eine andere Möglichkeit der Umrüstung besteht darin, daß zwei austauschbare Ausführungen des Kontaktmoduls 44 zur Verfügung stehen, wobei in der ersten Ausführungsform die ersten und zweiten Steckplätze 46a, 46b und in der zweite Ausführungsform die ersten und dritten Steckplätze 46a, 46c mit stiftförmigen Kontakten 48 besetzt sind. Eine dritte Möglichkeit der Umrüstung ergibt sich einerseits durch eine entsprechende Anordnung der Öffnungen 40 und Durchbrüche 42 im Anschlußmodul 16 sowie anderseits der Steckplätze 46a, 46b und 46c in einem mit nur zwei Paaren von stiftförmigen Kontakten 48 ausgestatteten Kontaktmodul 44, das in zwei um 180° zueinander versetzten Positionen im Oberteil 6 eingesetzt werden kann, so daß bei Wechsel der Position des Kontaktmoduls 44 die Verbindung zu dem jeweils anderen Energiebus hergestellt wird.

Die vorliegende Erfindung ist nicht auf die vorstehend beschriebenen Ausführungsformen beschränkt, sondern umfaßt auch alle im Sinne der Erfindung gleichwirkenden Ausführungsformen. So kann eine Umrüstung des Vernetzungsbausteins 2 beispielsweise auch in der Weise erfolgen, daß das Anschlußmodul 16 nur zwei Paare leitender Teile 24 aufweist und hinsichtlich der leitenden Teile 24 umrüstbar ist oder zwei sich hinsichtlich der Anordnung der leitenden Teile 24 unterscheidende Ausführungen umfaßt oder in zwei unterschiedliche Positionen überführbar ist, so daß entweder nur die erste und die zweite Busleitung 38a, 38b oder nur die erste und die dritte Busleitung 38a, 38c von den Anschlußmitteln 32 kontaktiert werden, wobei hier drei Paare von stiftförmigen Kontakten 48 im Oberteil 6 vorhanden sind. Für diese Fälle sind statt der trennbaren Kontaktmittel 34 und 48 auch nichttrennbare Kontaktmittel denkbar.

### Bezugszeichenliste:

- 2: Vemetzungsbaustein
- 4: Formgehäuse
- 6: Oberteil
- 8: Unterteil
- 10: Einrichtung
- 12: Motorschutzschalter
- 14: Schütz
- 16: Anschlußmodul
- 18: Deckelteil
- 20: Zwischenteil
- 22: Aufnahmeteil
- 24: leitendes Teil
- 28a; 28b; 28c: Ausnehmung
- 32: Anschlußmittel
- 34: aufnehmender Kontakt
- 36: Zwischenstück
- 38a; 38b; 38c: Busleitung
- 40: Öffnung
- 42: Durchbruch
- 44: Kontaktmodul
- 46a; 46b; 46c: Steckplätze
- 48: stiftförmiger Kontakt

## Patentansprüche

1. Vemefzungsbaustein für mindestens eine anzusteuernde und/oder ansteuernde elektrische Einrichtung (10), mit einem Formgehäuse (4) sowie mit Anschlußmitteln (32) für zwei mehradrige Busleitungen (38a; 38b), wobei die erste Busleitung (38a) als Logikbus und die zweite Busleitung (38b) als Energiebus zur Übertragung einer Hilfsenergie für die elektrischen Einrichtungen (10) dient, **dadurch gekennzeichnet, daß** Anschlußmittel (32) für eine dritte mehradrige Busleitung (38c) als weiterer Energiebus zur Übertragung einer weiteren Hilfsenergie für die elektrischen Einrichtungen (10) vorgesehen sind.

2. Vernetzungsbaustein nach Anspruch 1, **dadurch gekennzeichnet, daß** über die Anschlußmittel (32) für die dritte Busleitung (38c) eine über eine Notaus-Einrichtung abschaltbare Hilfsenergie und über die Anschlußmittel (32) für die zweite Busleitung (38b) eine bei Notaus nicht abschaltbare Hilfsenergie abzugreifen ist.

3. Vemetzungsbaustein nach Anspruch 1, **dadurch gekennzeichnet, daß** über die Anschlußmittel (32) für die zweite und die dritte Busleitung (38b; 38c) verschiedene, hinsichtlich ihrer Spannungshöhe und/oder ihrer Gleich- bzw. Wechselspannungseigenschaft unterschiedliche Hilfsenergien abzugreifen sind.

4. Vernetzungsbaustein nach Anspruch 1, **dadurch gekennzeichnet, daß** im Vernetzungsbaustein (2) elektrische Verbindungsmittel vorgesehen sind, die wahlweise entweder nur von der zweiten Busleitung (38b) oder nur von der dritten Busleitung (38c) die entsprechende Hilfsenergie für die elektrischen Einrichtungen (10) zur Verfügung stellen.

5. Vernetzungsbaustein nach Anspruch 4, **dadurch gekennzeichnet, daß** trennbare elektrische Kontaktmittel (34, 48) als Verbindungsmittel mit den räumlich getrennten Anschlußmitteln (32) verbunden sind.

6. Vernetzungsbaustein nach Anspruch 5, **dadurch gekennzeichnet, daß** die Kontaktmittel aus stiftförmigen Kontakten (48) und diese aufnehmenden Kontakten (34) bestehen.

7. Vernetzungsbaustein nach Anspruch 6, **dadurch gekennzeichnet, daß** die stiftförmigen Kontakte (48) hinsichtlich der Wahl der weiterzuleitenden Hilfsenergie versetzbar sind.

8. Vernetzungsbaustein nach Anspruch 6, **dadurch gekennzeichnet, daß** entweder die stiftförmigen oder die aufnehmenden Kontakte (48; 34) in einem im Formgehäuse (4) einzusetzenden Kontaktmodul (44) angeordnet sind.

9. Vernetzungsbaustein nach Anspruch 8, **dadurch gekennzeichnet, daß** das Kontaktmodul (44) hinsichtlich der Auswahl der weiterzuleitenden Hilfsenergie versetzbar ist.

10. Vernetzungsbaustein nach Anspruch 8, **dadurch gekennzeichnet, daß** zwei hinsichtlich der Auswahl der weiterzuleitenden Hilfsenergie austauschbare Ausführungen des Kontaktmoduls (44) vorgesehen sind.

11. Vernetzungsbaustein nach einem der Ansprüche 5 bis 10, **dadurch gekennzeichnet, daß** das Formgehäuse (4) aus einem Oberteil (6) und einem Unterteil (8) besteht und die Kontaktmittel (34, 48) trennbar zwischen Oberteil (6) und Unterteil (8) angeordnet sind.

12. Vernetzungsbaustein nach Anspruch 4, **dadurch gekennzeichnet, daß** ein die Anschlußmittel (32) enthaltendes Anschlußmodul (16) als Verbindungsmittel vorgesehen ist.

13. Vernetzungsbaustein nach Anspruch 12, **dadurch gekennzeichnet, daß** das Anschlußmodul (16) hinsichtlich der Auswahl der weiterzuleitenden Hilfsenergie versetzbar ist.

14. Vemetzungsbaustein nach Anspruch 12, **dadurch gekennzeichnet, daß** zwei hinsichtlich der Auswahl der weiterzuleitenden Hilfsenergie austauschbare Ausführungen des Anschlußmoduls (16) vorgesehen sind.

15. Vernetzungsbaustein nach einem der Ansprüche 12 bis 14, **dadurch gekennzeichnet, daß** das Formgehäuse (4) aus einem Oberteil (6) und einem Unterteil (8) besteht, Ausnehmungen (28a; 28b; 28c) im Bereich der Anschlußmittel (32) für die zwischen Oberteil (6) und Unterteil (8) einzulegenden Busleitungen (38a; 38b; 38c) vorgesehen sind und das Anschlußmodul (16) im Unterteil (8) angeordnet ist.

16. Vernetzungsbaustein nach Anspruch 1, **dadurch gekennzeichnet, daß** am Formgehäuse (4) Anschlußklemmen für die entsprechende Hilfsenergie von der zweiten und der dritten Busleitung (38b; 38c) vorgesehen sind.

17. Vernetzungsbaustein nach einem der vorstehenden Ansprüche, **dadurch gekennzeichnet, daß** weitere Anschlußmittel (32) zur Übertragung weiterer Hilfsenergien vorgesehen sind.

## Claims

1. Interconnection module for at least one electrical device (10) which can be driven and/or provides a drive, having a moulded housing (4) and having connecting means (32) for two multicore bus lines (38a; 38b), with the first bus line (38a) being used as a logic bus and the second bus line (38b) being used as a power bus for transmitting auxiliary power for the electrical devices (10), **characterized in that** connecting means (32) are provided for a third multicore bus line (38c) as a further power bus for transmitting further auxiliary power for the electrical devices (10).

2. Interconnection module according to Claim 1, **characterized in that** auxiliary power which can be switched off via an emergency off device can be tapped off via the connecting means (32) for the third bus line (38c), and auxiliary power which cannot be switched off by an emergency off can be tapped off via the connecting means (32) for the second bus line (38b).

3. Interconnection module according to Claim 1, **characterized in that** various auxiliary powers, which differ in their voltage magnitude and/or in their DC or AC voltage characteristic, can be tapped off via the connecting means (32) for the second and third bus lines (38b; 38c).

4. Interconnection module according to Claim 1, **characterized in that** the interconnection module (2) has electrical connection means which selectively provide the corresponding auxiliary power for the electrical devices (10) either only from the second bus line (38b) or only from the third bus line (38c).

5. Interconnection module according to Claim 4, **characterized in that** disconnectable electrical contact means (34, 48) are connected, as the connection means, to the physically separate connecting means (32).

6. Interconnection module according to Claim 5, **characterized in that** the contact means comprise contacts (48) in the form of pins, and contacts (34) holding them.

7. Interconnection module according to Claim 6, **characterized in that** the contacts (48) in the form of pins can be moved in order to select the auxiliary power to be passed on.

8. Interconnection module according to Claim 6, **characterized in that** either the contacts (48) in the form of pins or the contacts (34) holding them are arranged in a contact module (44) which can be inserted into the moulded housing (4).

9. Interconnection module according to Claim 8, **characterized in that** the contact module (44) can be moved in order to select the auxiliary power to be passed on.

10. Interconnection module according to Claim 8, **characterized in that** two versions of the contact module (44) are provided, which are interchangeable in order to select the auxiliary power to be passed on.

11. Interconnection module according to one of claims 5 to 10, **characterized in that** the moulded housing (4) comprises an upper part (6) and a lower part (8), and the contact means (34, 48) are arranged between the upper part (6) and the lower part (8) such that they can be disconnected.

12. Interconnection module according to Claim 4, **characterized in that** a connecting module (16) which contains the connecting means (32) is provided as the connection means.

13. Interconnection module according to Claim 12, **characterized in that** the connecting module (16) can be moved in order to select the auxiliary power to be passed on.

14. Interconnection module according to Claim 12, **characterized in that** two versions of the connecting module (16) are provided, which are interchangeable in order to select the auxiliary power to be passed on.

15. Interconnection module according to one of Claims 12 to 14, **characterized in that** the moulded housing (4) comprises an upper part (6) and a lower part (8), recesses (28a; 28b; 28c) are provided in the region of the connecting means (32) for the bus lines (38a; 38b; 38c) which are to be inserted between the upper part (6) and the lower part (8), and the connecting module (16) is arranged in the lower part (8).

16. Interconnection module according to Claim 1, **characterized in that** connecting terminals for the corresponding auxiliary power from the second and from the third bus lines (38b; 38c) are provided on the moulded housing (4).

17. Interconnection module according to one of the preceding claims, **characterized in that** further connecting means (32) are provided for transmitting further auxiliary powers.

## Revendications

1. Module d'interconnexion pour au moins un appareillage électrique (10) à commander et/ou de commande, comprenant un boîtier moulé (4) ainsi que des moyens de raccordement (32) pour deux câbles bus à plusieurs conducteurs (38a, 38b), le premier câble bus (38a) servant de bus logique et le deuxième câble bus (38b) servant de bus d'énergie pour la transmission d'une énergie auxiliaire pour les appareillages électriques (10), **caractérisé en ce que** des moyens de raccordement (32) sont prévus pour un troisième câble bus (38c) à plusieurs conducteurs faisant office de bus d'énergie supplémentaire pour la transmission d'une énergie auxiliaire supplémentaire pour les appareillages électriques (10).

2. Module d'interconnexion selon la revendication 1, **caractérisé en ce qu'**une énergie auxiliaire pouvant être coupée par le biais d'un dispositif d'arrêt d'urgence peut être collectée par le biais des moyens de raccordement (32) pour le troisième câble bus (38c) et une énergie auxiliaire ne pouvant pas être coupée peut être collectée par le biais des moyens de raccordement (32) pour le deuxième câble bus (38b).

3. Module d'interconnexion selon la revendication 1, **caractérisé en ce que** des énergies auxiliaires différentes du point de vue de leur niveau de tension et/ou de leurs propriétés de courant continu ou alternatif peuvent être collectées par le biais des moyens de raccordement (32) pour le deuxième et le troisième câble bus (38b, 38c).

4. Module d'interconnexion selon la revendication 1, **caractérisé en ce que** des moyens de connexion électriques sont prévus dans le module d'interconnexion (2), lesquels mettent l'énergie auxiliaire correspondante à la disposition des appareillages électriques (10) soit seulement par le deuxième câble bus (38b), soit seulement par le troisième câble bus (38c).

5. Module d'interconnexion selon la revendication 4, **caractérisé en ce que** des moyens de contact électrique séparables (34, 48) sont reliés avec les moyens de raccordement (32) séparés dans l'espace en faisant office de moyens de connexion.

6. Module d'interconnexion selon la revendication 5, **caractérisé en ce que** les moyens de contact se composent de contacts en forme de pointes (48) et de contacts (34) qui reçoivent ceux-ci.

7. Module d'interconnexion selon la revendication 6, **caractérisé en ce que** les contacts en forme de pointe (48) peuvent être décalés en fonction du choix de l'énergie auxiliaire à transmettre.

8. Module d'interconnexion selon la revendication 6, **caractérisé en ce que** les contacts en forme de pointe ou les contacts récepteurs (48, 34) sont disposés dans un module de contact (44) qui vient se loger dans le boîtier moulé (4).

9. Module d'interconnexion selon la revendication 8, **caractérisé en ce que** le module de contact (44) peut être décalé en fonction du choix de l'énergie auxiliaire à transmettre.

10. Module d'interconnexion selon la revendication 8, **caractérisé en ce que** deux exécutions du module de contact (44), interchangeables en fonction du choix de l'énergie auxiliaire à transmettre, sont prévues.

11. Module d'interconnexion selon l'une des revendications 5 à 10, **caractérisé en ce que** le boîtier moulé (4) se compose d'une partie supérieure (6) et d'une partie inférieure (8) et les moyens de contact (34, 48) sont disposés de manière séparable entre la partie supérieure (6) et la partie inférieure (8).

12. Module d'interconnexion selon la revendication 4, **caractérisé en ce qu'**un module de raccordement (16) contenant les moyens de raccordement (32) est prévu comme moyen de connexion.

13. Module d'interconnexion selon la revendication 12, **caractérisé en ce que** le module de raccordement (16) peut être décalé en fonction du choix de l'énergie auxiliaire à transmettre.

14. Module d'interconnexion selon la revendication 12, **caractérisé en ce que** deux exécutions du module de raccordement (16), interchangeables en fonction du choix de l'énergie auxiliaire à transmettre, sont prévues.

15. Module d'interconnexion selon l'une des revendications 12 à 14, **caractérisé en ce que** le boîtier moulé (4) se compose d'une partie supérieure (6) et d'une partie inférieure (8), que des évidements (28a, 28b, 28c) sont prévus dans la zone des moyens de raccordement (32) pour les câbles bus (38a, 38b, 38c) à placer entre la partie supérieure (6) et la partie inférieure (8) et le module de raccordement (16) est logé dans la partie inférieure (8).

16. Module d'interconnexion selon la revendication 1, **caractérisé en ce que** des bornes de raccordement sont prévues sur le boîtier moulé (4) pour l'énergie auxiliaire correspondante en provenance du deuxième et du troisième câble bus (38b, 38c).

17. Module d'interconnexion selon l'une des revendications précédentes, **caractérisé en ce que** des moyens de raccordement supplémentaires (32) sont prévus pour transmettre des énergies auxiliaires supplémentaires.
